(19) Europäisches Patentamt

European Patent Office

Office européen des brevets

(11) **EP 0 930 382 B1**

(12) **FASCICULE DE BREVET EUROPEEN**

(45) Date de publication et mention
de la délivrance du brevet:
**21.08.2002 Bulletin 2002/34**

(51) Int Cl.[7]: **C30B 25/02**, C30B 29/52

(21) Numéro de dépôt: **98403096.5**

(22) Date de dépôt: **09.12.1998**

(54) **Procédé d'obtention d'une couche de germanium ou de silicium monocristallin sur respectivement, un substrat de silicium ou germanium monocristallin, et produits multicouches obtenus**

Verfahren zur Herstellung einer Schicht einkristallinem Siliziums oder Germanium auf einem einkristallinen Substrat aus bzw Germanium oder Silizium und danach hergestellte mehrschichtförmige Produkte

Process for obtaining a layer of single crystal germanium or silicon on single cystal silicon or germanium substrate respectively, and multilayer products thus obtained

(84) Etats contractants désignés:
**DE GB IT NL**

(30) Priorité: **29.12.1997 FR 9716631**

(43) Date de publication de la demande:
**21.07.1999 Bulletin 1999/29**

(73) Titulaire: **FRANCE TELECOM**
**75015 Paris (FR)**

(72) Inventeurs:
• **Bensahel, Daniel**
**38000 Grenoble (FR)**
• **Campidelli, Yves**
**38000 Grenoble (FR)**
• **Hernandez, Caroline**
**38000 Grenoble (FR)**
• **Rivoire, Maurice**
**38240 Meylan (FR)**

(74) Mandataire: **Casalonga, Axel**
**BUREAU D.A. CASALONGA - JOSSE**
**Paul-Heyse-Strasse 33**
**80336 München (DE)**

(56) Documents cités:
**EP-A- 0 524 114**

• **MEYER ET AL: "The deposition of Si-Ge strained layers from GeH4, SiH2CI2, SiH4 and Si2H6" THIN SOLID FILMS., vol. 222, no. 1/2, 20 décembre 1992, pages 30-33, XP000345479 LAUSANNE CH**
• **FITZGERALD ET AL.: "Line point and surface defect morphology of graded,relaxed GeSi alloys on Si substrates" THIN SOLID FILMS., vol. 294, 1997, pages 3-10, XP002077187 LAUSANNE CH**
• **CHEN ET AL: "Epitaxy of Si1-xGex by ultrahigh vacuuum chemical vapor deposition using Si2H6 and GeH4" JAPANESE JOURNAL OF APPLIED PHYSICS., vol. 34, no. 2/7b, 15 juillet 1995, pages L869-L879, XP000702023 TOKYO JP**
• **AKETAGAWA ET AL.: "Selective epitaxial growth of Si and Si1-xGex films by ultrahigh vacuum chemical vapor deposition using Si2H6 and GeH4" JAPANESE JOURNAL OF APPLIED PHYSICS., vol. 31, no. 5a, mai 1992, pages 1432-1435, XP000355398 TOKYO JP**

## Description

La présente invention concerne de manière générale un procédé d'obtention d'une couche de germanium monocristallin sur un substrat de silicium monocristallin ou inversement d'une couche de silicium monocristallin sur un substrat de germanium monocristallin.

Le silicium (Si) est le composé de base de la micro-électronique. Il est disponible actuellement sur le marché en tranches de 200 mm de diamètre. Les limites en termes de performance des circuits intégrés sont donc en définitive celles liées aux propriétés intrinsèques du silicium. Parmi ces propriétés, on peut citer la mobilité électronique.

Le germanium (Ge) qui fait partie de la colonne IV de la classification périodique des éléments est un semi-conducteur. Il serait potentiellement plus intéressant que Si car, (i) il possède une mobilité électronique plus élevée, (ii) il absorbe bien dans le domaine du rayonnement infrarouge, (iii) son paramètre de maille est plus grand que celui de Si, ce qui autorise les hétéro-épitaxies avec les matériaux semiconducteurs des colonnes III-V de la classification périodique.

Malheureusement, le germanium ne possède pas d'oxyde stable et on ne trouve pas sur le marché de plaquettes de germanium de grand diamètre ou alors à des prix prohibitifs.

On a déjà fait croître des alliages $Si_{1-x}Ge_x$ sur des substrats de Si monocristallin. Les alliages obtenus ne dépassent que rarement des taux de 50% en germanium dans l'alliage.

Le document MEYER ET AL : « The deposition of Si-Ge strained layers from GeH4, SiH2Cl2, SiH4 and Si2H6 » THIN SOLID FILMS., vol. 222, no. 1/2, 20 décembre 1992, pages 30-33, XP000345479 LAUSANNE CH décrit deux études de dépôt de films mixtes $Si_{1-x}Ge_x$ :

a) l'une à température fixe (625°C) et à pression partielle de $GeH_4$ variable,
b) l'autre à température variable, mais à pression partielle fixe (38 mtorr).

D'autre part, lorsque l'on fait croître des alliages SiGe sur du Si monocristallin, la croissance de l'alliage SiGe est au départ monocristalline. Plus l'épaisseur de la couche et sa teneur en germanium sont élevées, plus la couche devient "contrainte". Au-delà d'une certaine épaisseur, la "contrainte" devient trop forte et la couche se relaxe en émettant des dislocations. Ces dislocations ont un effet délétère sur les futurs circuits qui seront construits sur cette couche et la relaxation des couches fait perdre certains avantages de la structure de bandes contrainte (décalage des bandes de conduction et de valence suivant les états de contrainte : Si/SiGe ou SiGe/Si). A chaque composition et à chaque température d'élaboration correspond donc une couche contrainte d'épaisseur maximum.

Dans certaines applications, on a développé le concept de "substrats relaxés", c'est-à-dire que l'on fait croître des couches de $Si_{1-x}Ge_x$ sur du silicium en dépassant l'épaisseur critique pour une composition donnée mais en ajustant les paramètres de dépôt des couches pour que les dislocations émises ne se propagent pas verticalement mais se courbent pour se propager dans le plan de la couche pour ensuite s'évaporer sur les bords de la plaque. La croissance s'effectue donc à partir de couches de plus en plus enrichies en germanium, le gradient en germanium pouvant se faire par palier ou continûment.

Mais les dépôts obtenus par ce procédé de "substrats relaxés" possèdent, soit un taux d'enrichissement en germanium relativement faible (< 50%), soit présentent une densité de dislocations émergentes inacceptable pour des applications en micro-électronique.

Ainsi, l'article intitulé "Stepwise equilibrated graded $Ge_xSi_{1-x}$ buffer with very low threading dislocation density on Si (001), G. Kissinger, T. Morgenstern, G. Morgenstern et H. Richter, Appl. Phy. Lett. 66 (16), 17 Avril 1995", décrit un procédé dans lequel on dépose sur un substrat la séquence de couches suivantes :

$$250 \text{ nm } Ge_{0,05}Si_{0,95} + 100 \text{ nm } Ge_{0,1}Si_{0,9}$$

$$+ 100 \text{ nm } Ge_{0,15}Si_{0,85} + 150 \text{ nm } Ge_{0,2}Si_{0,8}.$$

Chaque couche est, après dépôt, soumise à un recuit in situ dans l'hydrogène à 1095 ou 1050°C. A titre de comparaison, des séquences semblables de couches ont été déposées, mais sans recuit.

Une couche de 300 nm de $Ge_xSi_{1-x}$ de même composition que la couche tampon supérieure est également déposée sur celle-ci.

Les échantillons qui n'ont pas été soumis aux recuits intermédiaires présentent une densité de dislocations émergentes de $10^6$ $cm^{-2}$, cependant que l'échantillon ayant subi les recuits présente une densité de dislocations émergentes de $10^3$ - $10^4$ $cm^{-2}$.

L'article intitulé "Line, point and surface defect morphology of graded, relaxed GeSi alloys on Si substrates", E.A. Fitzgerald, S.B. Samavedam,Thin Solid Films, 294, 1997, 3-10, décrit la fabrication de substrats relaxés comportant jusqu'à 100% de germanium. Mais le procédé employé est long (de l'ordre de plus de 4 heures par plaque) et par conséquent inattractif du point de vue industriel. D'autre part, ce procédé n'est pas réversible, c'est-à-dire qu'il ne permet pas de réaliser des dépôts de silicium pur sur un substrat de germanium.

En outre, lors de la fabrication de tels substrats relaxés, on observe une rugosité de surface qui augmente suivant les conditions dépôt et qui peut avoir des effets négatifs car cumulatifs, c'est-à-dire qu'un début de rugosité ne fait que s'amplifier au cours du dépôt.

La présente invention a donc pour objet un procédé d'obtention sur un substrat en silicium monocristallin d'une couche de $Si_{1-x}Ge_x$ ayant une teneur élevée en germanium et pouvant être du germanium pur ayant une densité réduite de dislocations émergentes et l'inverse.

La présente invention a encore pour objet un procédé d'obtention d'une couche $Si_{1-x}Ge_x$ ayant une teneur élevée en germanium ayant une très faible rugosité de surface.

La présente invention a également pour objet un procédé tel que défini ci-dessus qui peut être mis en oeuvre dans un réacteur industriel, par exemple un réacteur mono-plaque industriel.

Selon l'invention, le procédé d'obtention sur un substrat de silicium monocristallin ou de germanium monocristallin d'une couche de germanium monocristallin ou de silicium monocristallin, respectivement, comprend le dépôt chimique en phase vapeur à partir d'un mélange de gaz précurseurs du germanium et du silicium, d'une couche de silicium ou germanium monocristallin, ledit procédé étant caractérisé par le fait que :

a) pour le dépôt de la couche de germanium monocristallin, on diminue progressivement la température de dépôt dans l'intervalle de 800°C à 450°C, de préférence 650 à 500°C, en simultanément accroissant progressivement le rapport pondéral Ge/Si dans le mélange de gaz précurseurs de 0 à 100%; et

b) pour le dépôt de la couche de silicium monocristallin, on accroît progressivement la température de dépôt dans l'intervalle de 450 à 800°C, de préférence 500 à 650°C, en simultanément accroissant progressivement le rapport pondéral Si/Ge dans le mélange de gaz précurseurs de 0 à 100%.

On peut utiliser dans le procédé de l'invention tous gaz précurseurs de Si et Ge, tels que $SiH_4$, $Si_2H_6$, $SiH_2Cl_2$, $SiHCl_3$, $SiCl_4$, $Si(CH_3)_4$ et $GeH_4$.

Les précurseurs préférés sont $SiH_4$ et $GeH_4$.

De préférence, comme cela est bien connu, les gaz précurseurs sont dilués dans un gaz vecteur tel que l'hydrogène. Les facteurs de dilution peuvent varier de 10 à 1000.

Le dépôt en phase vapeur s'effectue de préférence à basse pression, typiquement 8 kPa, mais peut être également mis en oeuvre à la pression atmosphérique en adaptant les phases gazeuses.

On a déterminé qu'une pression de l'ordre de 8 kPa (60 Torr) conduisait au meilleur compromis de vitesse de croissance élevée des couches et de contrôle du dépôt.

De préférence encore, on soumet la surface du substrat à une étape de préparation préalable au dépôt.

Cette étape de préparation peut être classiquement une étape de nettoyage de la surface, par exemple tout procédé en phase liquide ou gazeuse qui nettoie la surface de silicium des résidus métalliques et organiques, comme les solutions classiques SCl ($NH_4OH + H_2O_2$) et $SC_2$ ($HCl + H_2O_2$) ou encore $H_2SO_4 + H_2O_2$. Dans tous les cas, le nettoyage s'achève par une phase de traitement par une solution aqueuse diluée de HF suivie d'un rinçage à l'eau.

De préférence, le procédé selon l'invention s'effectue par paliers de durée définie au cours desquels on modifie linéairement la température et les flux de gaz en fonction du temps. En d'autres termes, dans le cas par exemple du dépôt d'une couche de germanium pur sur un substrat de silicium, la température est abaissée depuis la température maximale de dépôt jusqu'à la température minimale par paliers de durée déterminée au cours desquels on diminue linéairement la température depuis une première valeur jusqu'à une seconde valeur. Dans ce même intervalle de temps, on fait croître linéairement le rapport pondéral Ge/Si dans le mélange de gaz précurseurs, par exemple en faisant varier les flux des gaz précurseurs. Le dernier palier est celui pour lequel on a atteint la température minimale de dépôt et dans lequel le rapport pondéral Ge/Si du mélange de gaz précurseurs est 100/0. La durée de ce dernier palier est fonction de l'épaisseur voulue pour la couche de germanium pur.

Le nombre et la durée des paliers peuvent être déterminés en fonction de la durée totale du procédé de dépôt et de l'optimisation de la qualité du dépôt. En général, on choisit une durée totale de dépôt d'une heure environ, ce qui correspond à un compromis industriellement acceptable entre la qualité du dépôt (minimum de rugosité de surface pour une épaisseur totale donnée) et durée totale du dépôt.

On peut, si on le souhaite, intercaler entre chaque palier à température et flux variables, des paliers de dépôt à température fixe mais flux variable et inversement.

Pour faire croître du Si pur sur du Ge pur, il suffit de procéder comme précédemment mais en inversant le sens des variations de température et de flux.

On peut donc par le procédé selon l'invention réaliser des empilements successifs de couches de germanium pur et de silicium pur sur un substrat de germanium ou de silicium monocristallin.

Le procédé de l'invention est de préférence mis en oeuvre dans un réacteur monoplaque qui autorise une maniabilité plus grande des paramètres (changement plus rapide des compositions gazeuses et de la température). Toutefois, on peut utiliser tout autre dispositif approprié tel que, par exemple, un four.

Dans une autre réalisation de l'invention, on met en oeuvre alternativement les étapes de dépôt (a) et (b) ci-dessus pour obtenir un produit multicouches ayant des couches alternées de silicium et germanium monocristallin.

La présente invention concerne donc également des produits multicouches constitués, par exemple, par des empilements de structure : Si(monocristallin)/Si$_{1-x}$Ge$_x$ (x variant de 0 à 1)/Ge (monocristallin); Si (monocristallin) / Si$_{1-x}$Ge$_x$ (x variant de 0 à 1) / Si$_{1-y}$Ge$_y$ (y variant de 1 à 0)/Si(monocristallin); Si(monocristallin) /Si$_{1-x}$Ge$_x$ (x variant de 0 à 1)/Ge (monocristallin)/ Si$_{1-y}$Ge$_y$ (y variant de 1 à 0)/Si(monocristallin); Ge (monocristallin)/Si$_{1-x}$Ge$_x$ (x variant de 1 à 0)/Si(monocristallin); Ge(monocristallin)/Si$_{1-x}$Ge$_x$ (x variant de 1 à 0)/ Si$_{1-y}$Ge$_y$ (y variant de 0 à 1)/Ge (monocristallin); Ge(monocristallin)/Si$_{1-x}$Ge$_x$ (x variant de 1 à 0)/Si (monocristallin) /Si$_{1-y}$Ge$_y$ (y variant de 0 à 1 /Ge (monocristallin), et des combinaisons de ces empilements.

Les produits multicouches selon l'invention présentent en général une densité de dislocations émergentes ≤ 10$^3$/cm$^2$.

Bien que le procédé décrit ci-dessus limite l'apparition d'une rugosité de surface, il est encore souhaitable de réduire la rugosité de surface du dépôt de Si$_{1-x}$Ge$_x$.

Ainsi, les échantillons de plaques obtenus par le procédé décrit ci-dessus peuvent présenter une double rugosité de surface, à savoir une faible rugosité en forme de "tissus hâchurés" de faible amplitude (< 60 nm) et une forte rugosité (> 100 nm pic-vallée) de plus grande longueur d'onde.

Pour supprimer cette rugosité, on peut prévoir une étape de polissage mécano-chimique supprimant, soit seulement la forte rugosité, soit la totalité de la rugosité. Cette étape de polissage mécano-chimique peut être mise en oeuvre sur des couches Si$_{1-x}$Ge$_x$ pour toutes concentrations en germanium. Ainsi, le polissage mécano-chimique peut être mis en oeuvre sur une couche de Ge ou Si pur ou sur toute couche intermédiaire avant le dépôt de la couche de Ge ou Si pur. En outre, de manière préférentielle, on met en oeuvre cette étape de polissage mécano-chimique sur une couche de Si$_{1-x}$Ge$_x$ pour laquelle x < 1 ou x > 0, ce qui permet de déposer sur la couche de Si$_{1-x}$Ge$_x$ ainsi polie, au moyen du procédé décrit ci-dessus, des couches relaxées de Si$_{1-x}$Ge$_x$ en concentrations en Ge ou Si croissantes, en partant d'un dépôt ayant la même concentration en Ge et Si que la couche polie, jusqu'à obtenir une couche de Ge ou Si pur. La couche finale ainsi obtenue est pratiquement exempte de rugosité.

On peut utiliser dans la présente invention tout type de polissage mécano-chimique classiquement utilisé dans la technologie du silicium.

Le principe du polissage mécano-chimique est connu et classique et consiste à frotter la plaque à polir sur un tissu imbibé d'abrasif, en appliquant une pression et un déplacement sur cette plaque par rapport au tissu. Pour plus de détails, on peut se référer aux brevets. Les effets mécaniques et chimiques conjugués provoquent le retrait de molécules du matériau poli préférentiellement sur les zones en relief et induisent l'aplanissement du matériau à polir.

Le contrôle du polissage se fait, soit in-situ par contrôle de données du polissage comme le courant des moteurs, soit ex-situ de façon qualitative par observation optique ou microscopique, et/ou de façon quantitative par technique de microscopie à force atomique [mesure de la rugosité moyenne (rms) ou sommet/vallée].

Après polissage, il peut subsister des résidus mécaniques (incrustés) sur la surface qui seront enlevés par un brossage mécanique et rinçage.

Après ce nettoyage, le polissage peut laisser une zone perturbée en surface et un traitemnt de régénération de la surface peut être nécessaire. Ce traitement qui sera de type gravure devra néanmoins être effectué sans faire disparaître toute la couche active. Plusieurs voies sont possibles.

On peut, soit (i) graver par voie sèche ou humide la couche, soit (ii) oxyder la surface puis dissoudre l'oxyde. Ces deux moyens utiliseront la sensibilité extrême du Ge à l'oxygène (gazeux ou ozone ou ozone dissout dans l'eau, ou plasma ...), les oxydes de Ge étant volatils ou instables.

On peut, après ces traitements, reprendre une épitaxie sur la surface, en particulier selon le procédé de l'invention décrit ci-dessus. Dans ce cas préféré, on obtient immédiatement l'état de la surface voulu (comptage de défauts) et donc une couche "garantie" dont on peut ajuster l'épaisseur en fonction de l'application envisagée. De plus, on obtient un piégeage des impuretés par le réseau de dislocation sous-jacent.

Comme indiqué précédemment, la technique décrite ci-dessus est applicable pour toutes les concentrations de Ge dans la couche de Si$_{1-x}$Ge$_x$ et donne de très bons résultats en termes de planéité et de défauts résiduels en surface.

Néanmoins, pour les concentrations au-delà de typiquement 70% en Ge, on peut voir apparaître après polissage des "trous" qui correspondent à des défauts qui se sont transférés dans la couche supérieure. La densité de ces trous est de l'ordre de 10$^4$ et 10$^5$ df/cm$^2$. Ces trous ne sont évidemment pas polis ... Ces défauts sont vraisemblablement des fautes d'empilement ("stacking faults") et/ou des défauts liés au raccordement entre deux plans de glissement orthogonaux (directions <110>) des dislocations émises pour relaxer la structure en croissance. Deux types de "trous" peuvent exister :

(i) des trous dont la profondeur n'excède pas la couche supérieure de composition constante. Pour s'affranchir de ces trous, il faut déposer une épaisseur suffisante de la composition finale voulue de couche supérieure (Ge pur typiquement) et polir jusqu'à disparition des "trous".
(ii) des trous "plus profonds", de forme pyramidale inversée [sur substrat de Si monocristallin (100)] : le sommet de la pyramide inversée se trouve dans les couches à composition graduelle, le plus souvent au-delà de 55% en [Ge]. Ces trous, à bords rectangulaires francs sont arrondis de différentes façons avec le polissage, mais au détriment d'une plus grande zone d'extension. Pour limiter ces trous, une technique consiste à introduire dans les paliers de croissance et au-delà des 55% en Ge, des étapes où la composition est constante (typiquement 300 nm tous les 10%, ce qui augmente le temps de procédé par plaquette, qui reste encore néanmoins acceptable). Cela a pour effet de réduire la densité de ces défauts.

(iii) une autre possibilité pour limiter l'extension des trous "plus profonds" consiste à fabriquer un substrat jusqu'à des concentrations de l'ordre de 70%, de polir, nettoyer et reprendre la croissance en augmentant la concentration en Ge des couches jusqu'à celle désirée. Ceci peut être effectué autant de fois que nécessaire. On obtient ainsi des densités de défauts et une extension de ces défauts plus faible.

Cette variante du procédé selon l'invention présente plusieurs avantages :

- On peut utiliser pour le polissage mécano-chimique des appareils et des solutions de polissage classiquement utilisés dans la technologie du silicium.
- Il ne faut polir que très peu de matière et qui de plus apparaît en pic/vallée (de l'ordre de 200 nm en général). Cela laisse beaucoup de latitude et l'utilisation de solutions de PMC identiques à celles du silicium.
- La disparition de la zone "écrouie" après polissage est facile à mettre en oeuvre car les composés de Ge avec l'oxygène sont très instables, i.e., ils se dissolvent dans tout procédé contenant de l'oxygène (oxydation thermique ou assistée plasma, dissolution dans de l'eau ozonée ou dans des solutions chimiques attaquant sélectivement le Ge ...).
- Il s'agit d'un polissage "léger", c'est-à-dire avec une grande latitude de procédé dans le choix de l'épaisseur, de l'uniformité si l'on a pris soin d'élaborer au départ une couche relativement épaisse à polir (typiquement >2 fois la rugosité pic à pic à faire disparaître).
- La ré-épitaxie d'une couche de même composition que celle qui vient d'être polie va "garantir" la surface et permettre de repartir dans d'autres évolutions (autres couches relaxées ou contraintes au-dessus), c'est-à-dire que l'on part d'une surface sans rugosité.
- Cette technique peut s'étendre au cas inverse, c'est-à-dire l'obtention de couches de Si sur du Ge.

La suite de la description se réfère aux figures annexées qui représentent, respectivement :

Figure 1 - un graphe des températures de dépôt en fonction du temps (courbe A), ainsi qu'un graphe du rapport des débits des gaz précurseurs (GeH$_4$/SiH$_4$) en fonction du temps (courbe B) ;

Figure 2 - des graphes des débits des gaz précurseurs SiH$_4$ (courbe C) et GeH$_4$ (courbe D) en fonction du temps, ainsi qu'un graphe du rapport des débits de ces gaz précurseurs en fonction du temps (courbe B) ; et

Figure 3 - une microphotographie (x 10 000) d'un substrat revêtu, selon l'invention, d'un empilement de couches Si$_{1-x}$Ge$_x$ (x variant de 0 à 1) / Ge/ Si$_{1-x}$Ge$_x$ (x variant de 1 à 0) / Si.

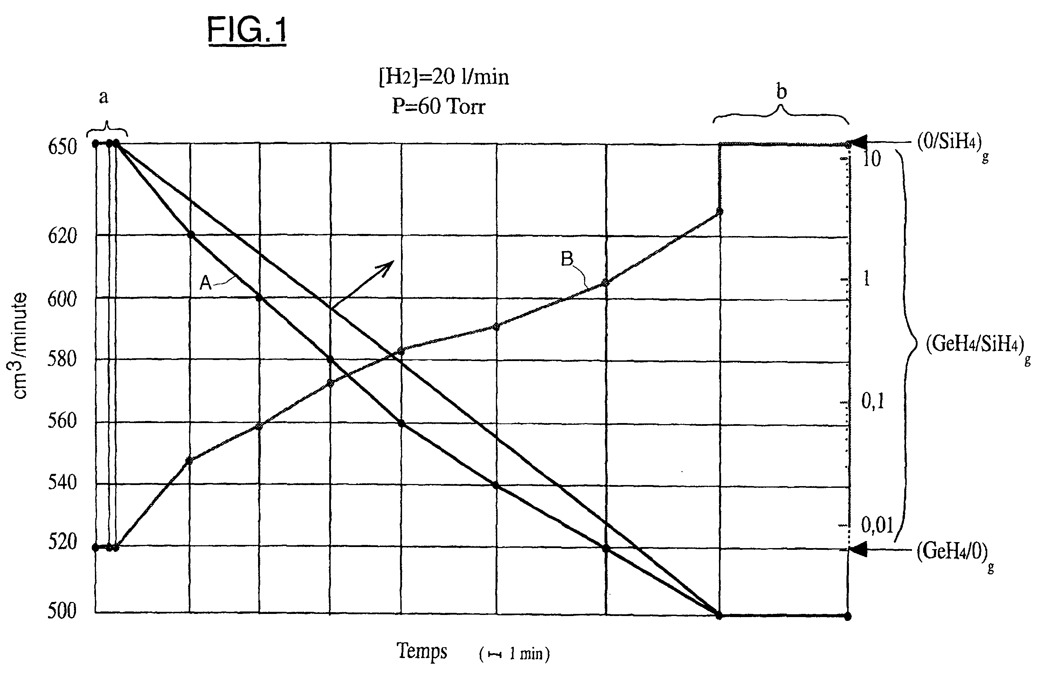

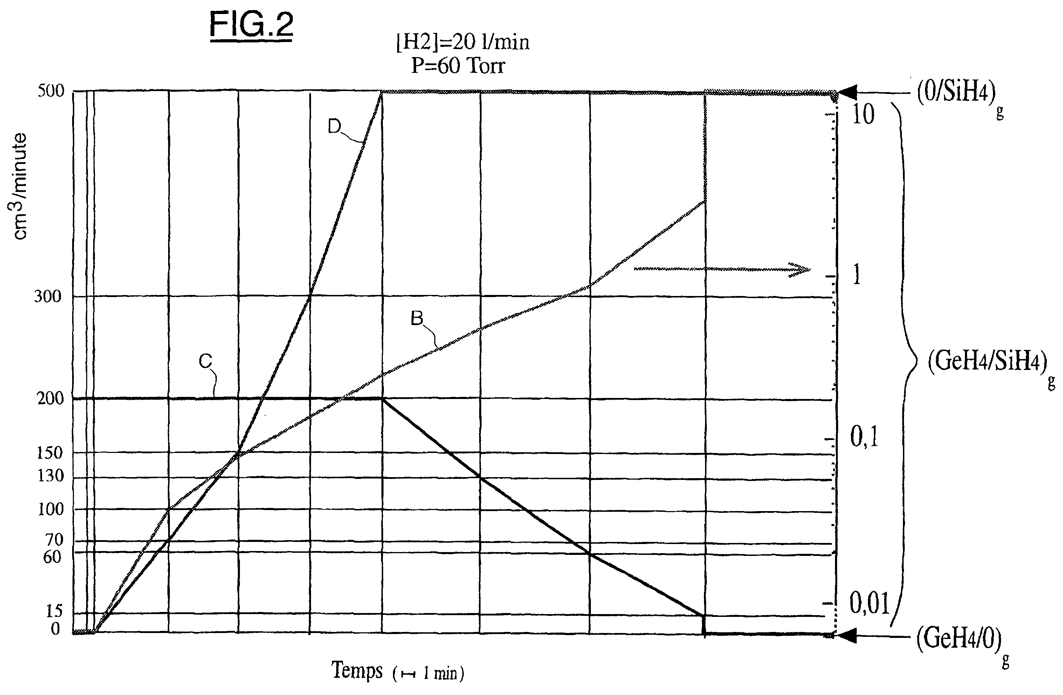

En se référant aux figures 1 et 2, on va maintenant décrire le procédé de l'invention dans le cas d'un dépôt de germanium sur un substrat de silicium monocristallin.

Les gaz précurseurs utilisés pour le dépôt chimique en phase vapeur sont GeH$_4$ et SiH$_4$. Le gaz vecteur est l'hydrogène (H$_2$) à un débit de 60 l/minute. La pression totale dans le réacteur est de 8 kPa (60 Torr).

Comme le montre la figure 2, les débits de SiH$_4$ et de GeH$_4$ dilué à 10% dans H$_2$, varient entre 0 et 200 cm$^3$/minute et entre 0 et 500 cm$^3$/minute.

En se référant à la figure 1, on fait varier la température du dépôt chimique en phase vapeur depuis 650°C jusqu'à 500°C par paliers en faisant varier simultanément le rapport pondéral Ge/Si dans le mélange de gaz précurseurs, par exemple en faisant varier les débits de SiH$_4$ et GeH$_4$ comme représenté à la figure 2 par les courbes C et D.

La partie a de la courbe A de la figure 1 correspond au dépôt à 650°C d'une couche épitaxiée de silicium pur (couche tampon) servant uniquement à assurer un bon départ des dépôts épitaxiaux ultérieurs. Cette couche tampon peut être supprimée selon la qualité du nettoyage du substrat de Si ou des plaques de Si fournies par le fabriquant.

La partie b correspond au dépôt à 500°C d'une couche de germanium pur. L'épaisseur de cette couche bien évidemment dépendra de la durée de cette phase de dépôt et est fonction de l'utilisation ultérieure envisagée.

Dans la mise en oeuvre du procédé de l'invention représentée aux figures 1 et 2, la variation de température s'effectue par palier et, simultanément, on fait varier par palier le rapport pondéral Ge/Si dans le mélange de gaz précurseurs.

Ainsi, pour passer de la température de 650°C à 620°C, on fixe les deux températures et le temps de passage de 650°C à 620°C. Il y a interpolation linéaire entre les deux températures.

La même procédure est employée pour la variation des flux respectifs des gaz précurseurs. Ainsi, comme le montre la figure 2, pendant le même intervalle de temps que l'on abaisse la température de 650°C à 620°C, on fait croître le débit de GeH$_4$ de 0 à 70 cm$^3$/minute tout en maintenant le débit de SiH$_4$ à 200 cm$^3$/minute, en augmentant ainsi le taux de germanium dans la couche d'alliage GeSi déposée.

On répète cette procédure par paliers de température en accroissant le flux de $GeH_4$ par paliers jusqu'à atteindre 500 $cm^3$/minute, pour une température choisie (par exemple une température de 560°C). A partir de cette température, le flux de $GeH_4$ est maintenu à 500 $cm^3$/minute et le flux de $SiH_4$ est abaissé par paliers de 200 $cm^3$ jusqu'à 0, cependant que la température est abaissée simultanément par paliers de 560 à 500°C.

De préférence, la courbe d'abaissement de températures doit être située en dessous de la droite reliant les températures extrêmes, c'est-à-dire doit être une courbe concave. Plus la concavité est importante, meilleure est la qualité des couches déposées (minimum de rugosité pour une épaisseur totale donnée). Mais, plus cette concavité est importante, plus long est le procédé. Généralement, on choisira une concavité telle, et par conséquent un nombre de paliers, pour que la durée du procédé de dépôt soit acceptable industriellement, par exemple une heure environ.

Le procédé selon l'invention, illustré par les figures 1 et 2, a été mis en oeuvre dans un réacteur mono-plaque (plaque 200 mm) ayant un taux de fuite inférieur à 1,33 Pa/minute (10 mTorr/minute) pour éviter une contamination par $H_2O$ et $O_2$ délétère pour le germanium.

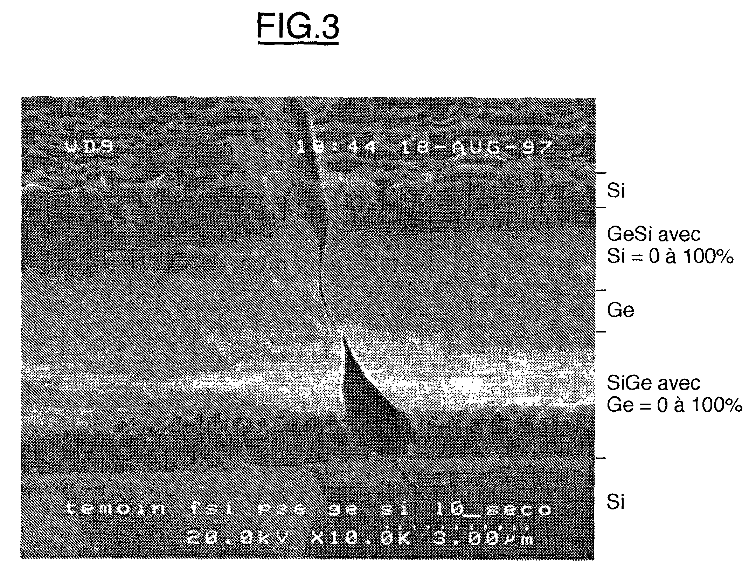

La figure 3 est une microphotographie d'un produit multicouche préféré, selon l'invention.

La rugosité observée sur la microphotographie (quelle soit dans le plan de coupe ou sur la surface) ne résulte que d'une décoration chimique de l'échantillon, décoration qui vise simplement à amplifier visuellement le contraste entre les différentes couches de la structure.

Ce produit multicouche comprend la structure suivante :

Si (substrat monocristallin) / $Si_{1-x}Ge_x$ (x variant de 0 à 1)

Ge (monocristallin) / $Si_{1-y}Ge_y$ (y variant de 1 à 0) / Si (monocristallin).

On ne retrouve pas dans ce produit multicouche de réseau de dislocations émergentes.

On a effectué le polissage mécano-chimique des plaques multicouches obtenu par le procédé ci-dessus ayant une couche supérieure de Ge pur d'épaisseur de l'ordre de 400 nm sur une machine industrielle de marque Presi®, type E550, avec un tissu Rodel®, référence IC400 (un tissu dit "dur") et un abrasif Clariant®, référence Klebosol 30N50PHN (un abrasif standard de la technologie silicium). Les paramètres de procédé typique qui ont été utilisés pour polir les plaques multicouches sont les suivants : pression à 0,3 $DaN/cm^2$, vitesse plateau et tête de 0,8 m/sec, température de 15°C. En fin de polissage, une étape de rinçage est effectuée à une pression de 0,15 $DaN/cm^2$ et des vitesses de 1,4 m/sec, l'abrasif étant remplacé par de l'eau déionisée. Après polissage, les plaques sont brossées (à l'eau

déionisée et $NH_4OH$) et séchées dans un machine de marque Ontrack®, type SS200, de manière classique.

Bien évidemment, les différents paramètres ci-dessus peuvent être modifiés dans une large mesure en fonction de la couche polie et du résultat recherché.

On retiendra que la vitesse d'attaque du SiGe est ≤80 nm/min avec une non-uniformité sur des plaques de diamètre de 200 mm inférieure à 3%.

Le taux de particules de 0,2 $\mu$m (hors trous profonds) est inférieur à 0,8 défaut/$cm^2$ et aucune microrayure n'a été décelée.

L'aplanissement des pics après le polissage mécano-chimique induit une rugosité de l'ordre de 1 nm (valeur quadratique moyenne) pour 5 minutes de polissage, en ayant démarré avec une couche de Ge présentant des variations pic/vallée de 200 nm.

## Revendications

1. Procédé d'obtention sur un substrat de silicium ou germanium monocristallin d'une couche de germanium ou de silicium monocristallin, respectivement, par dépôt chimique en phase vapeur à partir d'un mélange de gaz précurseurs de silicium et de germanium, **caractérisé par le fait que** :

   a) pour le dépôt de la couche de germanium monocristallin, on diminue progressivement la température de dépôt dans l'intervalle de 800°C à 450°C, de préférence 650 à 500°C, en simultanément accroissant progressivement le rapport pondéral Ge/Si dans le mélange de gaz précurseurs de 0 à 100%; et

   b) pour le dépôt de la couche de silicium monocristallin, on accroît progressivement la température de dépôt dans l'intervalle de 450 à 800°C, de préférence 500 à 650°C, en simultanément accroissant progressivement le rapport pondéral Si/Ge dans le mélange de gaz précurseurs de 0 à 100%.

2. Procédé selon la revendication 1, **caractérisé en ce que** l'accroissement ou la diminution de la température se fait linéairement par paliers de durée choisie, et l'accroissement du rapport pondéral Ge/Si ou Si/Ge se fait linéairement durant ces paliers.

3. Procédé selon la revendication 1 ou 2, **caractérisé en ce que** l'accroissement des rapports pondéraux Ge/Si et Si/Ge se fait en modifiant les débits des gaz précurseurs.

4. Procédé selon l'une quelconque des revendications précédentes, **caractérisé en ce que** les gaz précurseurs sont $SiH_4$ et $GeH_4$.

5. Procédé selon l'une quelconque des revendications précédentes, **caractérisé en ce qu'**il est mis en oeuvre dans un réacteur mono-plaque.

6. Procédé selon l'une quelconque des revendications précédentes, **caractérisé en ce qu'**on met en oeuvre alternativement les étapes de dépôt (a) et (b) pour obtenir un produit multicouche ayant des couches alternées de silicium et germanium monocristallin.

7. Procédé selon l'une quelconque des revendications précédentes, **caractérisé en ce qu'**il comprend en outre une étape de polissage mécano-chimique de la couche de germanium ou de silicium monocristallin.

8. Procédé selon l'une quelconque des revendications 1 à 7. **caractérisé en ce qu'**il comprend une ou plusieurs étapes de polissage mécano-chimique de la surface revêtue du substrat avant dépôt de Ge ou Si pur.

9. Produit multicouche, **caractérisé en ce qu'**il est constitué par des empilements de structure choisis parmi :

Si(monocristallin)/$Si_{1-x}Ge_x$ (x variant de 0 à 1) /Ge (monocristallin); Si(monocristallin) / $Si_{1-x}Ge_x$ (x variant de 0 à 1) /$Si_{1-y}Ge_y$ (y variant de 1 à 0)/Si(monocristallin); Si(monocristallin)/ $Si_{1-x}Ge_x$ (x variant de 0 à 1)/Ge (monocristallin) /$Si_{1-y}Ge_y$ (y variant de 1 à 0)/Si(monocristallin); Ge (monocristallin)/$Si_{1-x}Ge_x$ (x variant de 1 à 0)/Si(monocristallin): Ge(monocristallin)/ $Si_{1-x}Ge_x$ (x variant de 1 à 0)/$Si_{1-y}Ge_y$ (y variant de 0 à 1)/Ge (monocristallin); Ge(monocristallin)/$Si_{1-x}Ge_x$ (x variant de 1 à 0)/Si (monocristallin) /$Si_{1-y}Ge_y$ (y variant de 0 à 1 /Ge (monocristallin), et des combinaisons de ces empilements et **en ce que** la densité de dislocations émergentes est inférieure ou égale à $10^3/cm^2$.

**Patentansprüche**

1. Verfahren zum Herstellen einer Schicht aus einkristallinem Germanium oder Silizium auf einem Substrat aus einkristallinem Silizium bzw. Germanium durch chemisches Abscheiden in der Dampfphase aus einer Mischung von Vorläufergasen von Silizium und Germanium **dadurch gekennzeichnet, dass**:

(a) für das Abscheiden der Schicht aus einkristallinem Germanium die Temperatur der Abscheidung in dem Intervall von 800°C bis 450°C, vorzugsweise 650 bis 500°C, fortschreitend verringert wird, wobei gleichzeitig das Gewichtsverhältnis Ge/Si in der Mischung von Vorläufergasen von 0 bis 100% fortschreitend erhöht wird; und
(b) für das Abscheiden der Schicht aus einkristallinem Silizium die Temperatur des Abscheidens in dem Intervall von 450°C bis 800°C, vorzugsweise 500 bis 650°C, fortschreitend erhöht wird, wobei gleichzeitig das Gewichtsverhältnis Si/Ge in der Mischung von Vorläufergasen von 0 bis 100% fortschreitend erhöht wird.

2. Verfahren nach Anspruch 1, **dadurch gekennzeichnet, dass** die Zunahme oder die Verminderung der Temperatur in Stufen einer gewählten Dauer erfolgt, und die Zunahme des Gewichtsverhältnis Ge/Si oder Si/Ge während dieser Stufen linear erfolgt.

3. Verfahren nach Anspruch 1 oder 2, **dadurch gekennzeichnet, dass** die Zunahme der Gewichtsverhältnisse Ge/Si und Si/Ge erfolgt, indem die Durchsätze der Vorläufergase modifiziert werden.

4. Verfahren nach einem der vorhergehenden Ansprüche, **dadurch gekennzeichnet, dass** die Vorläufergase $SiH_4$ und $GeH_4$ sind.

5. Verfahren nach einem der vorhergehenden Ansprüche, **dadurch gekennzeichnet, dass** es in einem Einplatten-Reaktor durchgeführt wird.

6. Verfahren nach einem der vorhergehenden Ansprüche, **dadurch gekennzeichnet, dass** die Abscheidungsschritte (a) und (b) alternativ durchgeführt werden, um ein mehrschichtiges Produkt zu erhalten, welches alternierende Schichten von einkristallinem Silizium und Germanium aufweist.

7. Verfahren nach einem der vorhergehenden Ansprüche, **dadurch gekennzeichnet, dass** es ferner einen Schritt zum mechano-chemischen Polieren der Schicht aus einkristallinem Silizium oder Germanium aufweist.

8. Verfahren nach einem der vorhergehenden Ansprüche 1 bis 7, **dadurch gekennzeichnet, dass** es einen oder mehrere Schritte zum mechano-chemischen Polieren der beschichteten Oberfläche des Substrats vor dem Abscheiden von reinem Ge oder Si aufweist.

9. Mehrschichtiges Produkt, **dadurch gekennzeichnet, dass** es durch Strukturstapel gebildet ist, welche gewählt sind aus: Si (einkristallin) / $Si_{1-x}Ge_x$ (x variiert von 0 bis 1)/ Ge (einkristallin); Si (einkristallin) / $Si_{1-x}Ge_x$ (x variiert von 0 bis 1) / $Si_{1-y}Ge_y$ (y variiert von 1 bis 0) / Si (einkristallin); Si(einkristallin) / $Si_{1-x}Ge_x$ (x variiert von 0 bis 1) / Ge (einkristallin) / $Si_{1-y}Ge_y$ (y variiert von 1 bis 0) / Si (einkristallin); Ge (einkristallin) / $Si_{1-x}Ge_x$ (x variiert von 1 bis 0) / Si (einkristallin); Ge (einkristallin) / $Si_{1-x}Ge_x$ (x variiert von 1 bis 0) / $Si_{1-y}Ge_y$ (y variiert von 0 bis 1) / Ge (einkristallin); Ge (einkristallin) / $Si_{1-x}Ge_x$ (x variiert von 1 bis 0) / Si (einkristallin) / $Si_{1-y}Ge_y$ (y variiert von 0 bis 1) / Ge (einkristallin), und Kombinationen dieser Stapel, und dass die Dichte an freigesetzten Versetzungen $\leq 10^3/cm^2$ ist.

## Claims

1. Process for obtaining a layer of single-crystal silicon or germanium on a substrate of single-crystal germanium or silicon, respectively, by chemical vapour deposition using a mixture of silicon and germanium precursor gases, **characterized in that**:

   a) in the case of deposition of the layer of single-crystal germanium, the deposition temperature is gradually decreased in the range of 800°C to 450°C, preferably 650 to 500°C, while at the same time gradually increasing the Ge/Si weight ratio in the precursor gas mixture from 0 to 100%; and

   b) in the case of deposition of the layer of single-crystal silicon, the deposition temperature is gradually increased in the range of 450 to 850°C, preferably 500 to 650°C, while at the same time gradually increasing the Si/Ge weight ratio in the precursor gas mixture from 0 to 100%.

2. Process according to Claim 1, **characterized in that** the temperature is increased or decreased linearly in stages of the desired duration and the Ge/Si or Si/Ge weight ratio is increased linearly during these stages.

3. Process according to Claim 1 or 2, **characterized in that** the Ge/Si and Si/Ge weight ratios are increased while modifying the flow rates of the precursor gases.

4. Process according to any of the preceding claims, **characterized in that** the precursor gases are $SiH_4$ and $GeH_4$.

5. Process according to any one of the preceding claims, **characterized in that** it is implemented in a single-wafer reactor.

6. Process according to any one of the preceding claims, **characterized in that** the deposition steps (a) and (b) are carried out alternately in order to obtain a multilayer product having alternate layers of single-crystal silicon and single-crystal germanium.

7. Process according to any one of the preceding claims, **characterized in that** it furthermore comprises a step of chemical-mechanical polishing of the layer of single-crystal germanium or of single-crystal silicon.

8. Process according to any one of Claims 1 to 7, **characterized in that** it comprises one or more steps of chemical-mechanical polishing of the coated surface of the substrate before deposition of the pure Ge or pure Si.

9. Multilayer product, **characterized in that** it consists of stacks having a structure chosen from among:

   Si(single-crystal)/$Si_{1-x}Ge_x$ (x varying from 0 to 1)/Ge(single-crystal); Si (single-crystal)/$Si_{1-x}Ge_x$ (x varying from 0 to 1)/$Si_{1-y}Ge_y$ (y varying from 1 to 0)/Si(single-crystal); Si (single-crystal)/$Si_{1-x}Ge_x$ (x varying from 0 to 1)/Ge(single-crystal)/$Si_{1-y}Ge_y$ (y varying from 1 to 0)/Si (single-crystal) ; Ge(single-crystal)/$Si_{1-x}Ge_x$ (x varying from 1 to 0)/Si(single-crystal); Ge(single-crystal)/$Si_{1-x}Ge_x$ (x varying from 1 to 0)/$Si_{1-y}Ge_y$ (y varying from 0 to 1)/Ge (single-crystal); Ge (single-crystal)/$Si_{1-x}Ge_x$ (x varying from 1 to 0)/Si (single crystal) /$Si_{1-y}Ge_y$ (y varying from 0 to 1/Ge (single crystal) and combinations of these stacks and **in that** the emergent-dislocation density is less than or equal to $10^3/cm^2$.

## FIG.1

$[H_2]=20$ l/min
$P=60$ Torr

a

b

$(0/SiH_4)_g$

10

1

B

A

$(GeH_4/SiH_4)_g$

$cm^3/minute$

0,1

0,01

$(GeH_4/0)_g$

Temps    ($\vdash$ 1 min)

EP 0 930 382 B1

FIG.2

$[H_2]=20$ l/min
$P=60$ Torr

Temps ( ⊢ 1 min )

EP 0 930 382 B1

## FIG.3

Si

GeSi avec
Si = 0 à 100%

Ge

SiGe avec
Ge = 0 à 100%

Si

EP 0 930 382 B1